# EUROPEAN PATENT APPLICATION

(11) **EP 1 914 860 A2**
(43) Date of publication of application: **23.04.2008**
(21) Application number: 07117224.1
(22) Date of filing: 26.09.2007
(51) Int. Cl.: H02J 7/00

(54) **Circuit Module**

(30) Priority: 19.10.2006 JP 2006285241
(71) Applicant: Mitsumi Electric Co., Ltd., Tama-shi, Tokyo 206-8567 (JP)
(72) Inventor: Miyamoto, Yoshiaki Mitsumi Electric Co., Ltd., Kanagawa Kanagawa 243-8533 (JP); Osamu, Tajima Mitsumi Electric Co., Ltd., Kanagawa Kanagawa 243-8533 (JP)
(74) Representative: Green, Mark Charles

(57) **Abstract**

A disclosed circuit module (100) is characterized by: a substrate (111); a protection circuit (112) mounted on the substrate (111) for protecting a battery; and a charging circuit (113) disposed on the substrate (111) for controlling charging and discharging of the battery.

## Description

### BACKGROUND OF THE INVENTION

### 1. Field of the Invention

The present invention generally relates to a circuit module and particularly to a circuit module in which a protection circuit for protecting a battery is mounted on a substrate

### 2. Description of the Related Art

In general, battery packs are used as a driving power supply for driving mobile devices such as mobile telephones. In the battery pack, usually, a lithium ion battery and a protection circuit are built in a single casing. The protection circuit detects an overcharge state, overdischarge state, and overcurrent state by detecting voltage and current of the lithium ion battery. When such states are detected, the protection circuit protects the lithium ion battery from falling into the overcharge state, overdischarge state, and overcurrent state by disconnecting between the lithium ion battery and an output terminal.

In this case, the protection circuit built in the battery pack is provided as a circuit module having a COB (chip on board) structure.

On the other hand, in mobile devices, the battery pack is desired to be used in common with other mobile devices.

In the following, a system of a mobile device driven using a conventional battery pack is described.

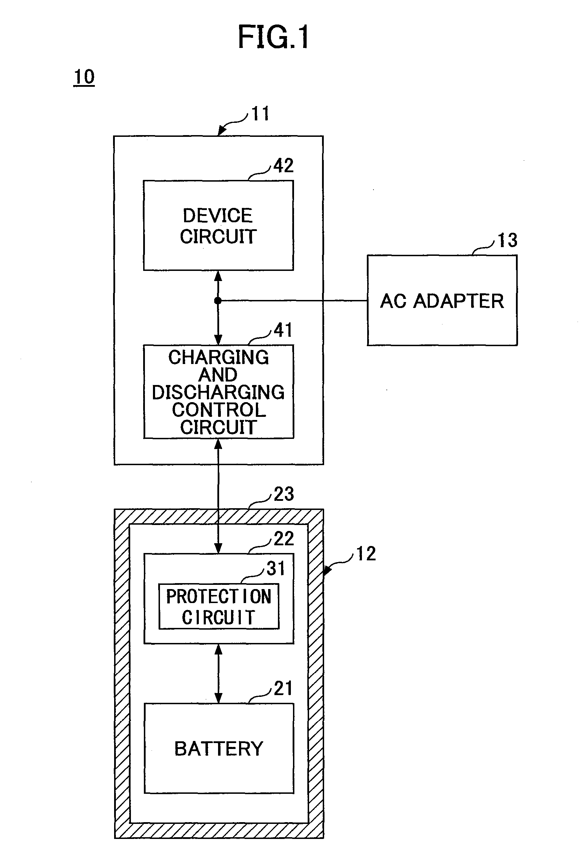

FIG. 1 is a diagram showing a system configuration of the mobile device driven using the battery pack.

A mobile device 10 includes a device body 11 and a battery pack 12. The battery pack 12 includes a battery 21 and a circuit module 22 stored in a case 23. A protection circuit 31 is mounted on the circuit module 22 (refer to Patent Document 1, for example).

The protection circuit 31 detects voltage, charging and discharging current, and ambient temperature of the battery 21 so as to detect a status immediately before abnormality such as the overcharge state, overdischarge state, overcurrent state, and overheat state. When such a status immediately before abnormality is detected, the protection circuit 31 protects the battery 21 from falling into the overcharge state, overdischarge state, overcurrent state, and overheat state by turning off a switching element connected between the battery 21 and a load in series. The protection circuit 31 is intended only to have a function of protecting the battery 21 from falling into the overcharge state, overdischarge state, overcurrent state, and overheat state, so that the protection circuit 31 is not provided with a function of controlling charging and discharging of the battery 21.

Conventionally, charging and discharging control of the battery 21 is performed by a charging and discharging control circuit 41 built in the device body 11. The charging and discharging control circuit 41 is connected between the battery pack 12 and a device circuit 42 built in the device body 11. The charging and discharging control circuit 41 controls voltage and current supplied from the battery 21 built in the battery pack 12 to the device circuit 42 and also controls a charging voltage applied from an AC adapter 13 to the battery 21 of the battery pack 12 and a charging current supplied from the AC adapter 13 to the battery 21 of the battery pack 12.

In this case, in the AC adapter 13, a rated current, rated voltage, and the like are set in accordance with functions and specification of the charging and discharging control circuit 41. Further, in the charging and discharging control circuit 41, the functions and specification are set in accordance with charging and discharging characteristics of the battery pack 12. Thus, the device body 11, battery pack 12, and AC adapter 13 are required to be used in a set. This hinders the battery pack from being used in common with other mobile devices.

There has been suggested a battery pack for common use in which a protection function and a charging function are built (refer to Patent Document 2, for example)
Patent Document 1: Japanese Laid-Open Patent Application No. 2004-6524
Patent Document 2: Japanese Laid-Open Patent Application No. 2004-296165

However, battery packs have been made thin and downsized, so that it is difficult to build the protection circuit and a charging circuit in the battery pack. Further, the charging circuit have large heat generation, so that when the protection
circuit and the charging circuit are disposed closely to each other, the protection circuit detects the overheat state of the battery due to heat from the charging circuit. Then, the battery is disconnected by the protection circuit and charging is disabled. Thus, there have been demands for a structure in which the protection circuit and the charging circuit are mounted with a reduced influence of heat and a small mounting space.

### SUMMARY OF THE INVENTION

It is a general object of the present invention to provide an improved and useful circuit module in which the above-mentioned problems are eliminated.

A more specific object of the present invention is to provide a circuit module that can modularize the protection circuit and the charging circuit with a small mounting space.

According to one aspect of the present invention, there is provided a circuit module characterized by: a substrate; a protection circuit mounted on the substrate for protecting a battery; and a charging circuit disposed on the substrate for controlling charging and discharging of the battery. Further, the protection circuit and the charging circuit may be sealed with resin. An electronic component constituting the protection circuit and an electronic component constituting the charging circuit may be mounted on a surface of one side of the substrate.

According to another aspect of the present invention, there is provided a circuit module characterized by: a first circuit substrate constituting a first circuit; and a second circuit substrate constituting a second circuit, wherein the first circuit substrate and the second circuit substrate are laminated and connected using a conductive member.

According to another aspect of the present invention, in the circuit module, an electronic component constituting the first circuit may be mounted on a surface of one side of the first circuit substrate, an electronic component constituting the second circuit may be mounted on a surface of one side of the second circuit substrate, and the first circuit substrate and the second circuit substrate may be laminated so as to dispose a surface of the other side of the first circuit substrate and the surface of one side of the second circuit substrate in an opposing manner and may be connected using the conductive member. Further, the first circuit substrate and the second circuit substrate may be laminated via a radiator plate and connected using the conductive member.

According to another aspect of the present invention, in the circuit module, an electronic component constituting the first circuit may be mounted on a surface of one side of the first circuit substrate, an electronic component constituting the second circuit may be mounted on a surface of one side of the second circuit substrate, and the first circuit substrate and the second circuit substrate may be laminated so as to dispose the surface of one side of the first circuit substrate and the surface of one side of the second circuit substrate in an opposing manner and may be connected using the conductive member.

According to another aspect of the present invention, in the circuit module, a clearance between the first circuit substrate and the second circuit substrate may be sealed with resin.

According to another aspect of the present invention, in the circuit module, an electronic component constituting the first circuit may be mounted on a surface of one side of the first circuit substrate, an electronic component constituting the second circuit may be mounted on a surface of one side of the second circuit substrate, and the first circuit substrate and the second circuit substrate may be laminated so as to dispose a surface of the other side of the first circuit substrate and a surface of the other side of the second circuit substrate in an opposing manner and may be connected using the conductive member.

According to another aspect of the present invention, in the circuit module, the first circuit may function as a protection circuit for protecting a battery, the second circuit may function as a charging circuit for controlling charging of the battery, and the conductive member may include a first conductive member connected to a power supply terminal and a second conductive member connected to a ground terminal.

According to the present invention, the charging circuit for controlling charging and discharging of the battery is further disposed on the substrate where the protection circuit for protecting the battery is mounted. Thus, it is possible to mount the protection circuit and the charging circuit on a single substrate and this enables charging with only a battery pack. Moreover, the protection circuit and the charging circuit are mounted on a single substrate, so that it is possible to downsize the circuit module.

According to the present invention, the first circuit substrate constituting the first circuit and the second circuit substrate constituting the second circuit are laminated and connected using the conductive material. Accordingly, it is possible to reduce transfer of heat between the first circuit and the second circuit. Thus, it is possible to mount the first circuit and the second circuit closely to each other, so that it is possible to construct the first circuit and the second circuit using a small-sized circuit module.

Other objects, features and advantage of the present invention will become more apparent from the following detailed description when read in conjunction with the accompanying drawings.

### BRIEF DESCRIPTION OF THE DRAWINGS

FIG. 1 is a diagram showing a configuration of a conventional system as an example;
FIG. 2A is a top view showing a configuration according to a first embodiment of the present invention;
FIG. 2B is a side elevational view showing a configuration according to a first embodiment of the present invention;
FIG. 2C is a bottom view showing a configuration according to a first embodiment of the present invention;
FIG. 3 is a diagram showing a block configuration according to a first embodiment of the present invention;
FIG. 4A is a top view showing a configuration according to a second embodiment of the present invention;
FIG. 4B is a side elevational view showing a configuration according to a second embodiment of the present invention;
FIG. 4C is a bottom view showing a configuration according to a second embodiment of the present invention;
FIG. 5 is a diagram showing a block configuration according to a second embodiment of the present invention;
FIG. 6A is a top view showing a configuration of a protection circuit substrate;
FIG. 6B is a side elevational view showing a configuration of a protection circuit substrate;
FIG. 6C is a bottom view showing a configuration of a protection circuit substrate;
FIG. 7A is a top view showing a configuration of a charging circuit substrate;
FIG. 7B is a side elevational view showing a configuration of a charging circuit substrate;
FIG. 7C is a bottom view showing a configuration of a charging circuit substrate;
FIG. 8A is a top view showing a configuration of a radiator plate;
FIG. 8B is a side elevational view showing a configuration of a radiator plate;
FIG. 8C is a bottom view showing a configuration of a radiator plate;
FIG. 9 is a diagram illustrating a method for assembling a circuit unit according to a second embodiment of the present invention;
FIG. 10A is a top view showing a configuration according to a third embodiment of the present invention;
FIG. 10B is a side elevational view showing a configuration according to a third embodiment of the present invention;
FIG. 10C is a bottom view showing a configuration according to a third embodiment of the present invention;
FIG. 11A is a bottom view showing a configuration of another protection circuit substrate;
FIG. 11B is a side elevational view showing a configuration of another protection circuit substrate;
FIG. 11C is a top view showing a configuration of another protection circuit substrate;
FIG. 12 is a diagram illustrating a method for assembling a circuit unit according to a third embodiment of the present invention;
FIG. 13A is a top view showing a configuration according to a fourth embodiment of the present invention;
FIG. 13B is a side elevational view showing a configuration according to a fourth embodiment of the present invention;
FIG. 13C is a bottom view showing a configuration according to a fourth embodiment of the present invention;
FIG. 14A is a top view showing a configuration of another protection circuit substrate;
FIG. 14B is a side elevational view showing a configuration of another protection circuit substrate;
FIG. 14C is a bottom view showing a configuration of another protection circuit substrate;
FIG. 15A is a bottom view showing a configuration of another charging circuit substrate;
FIG. 15B is a side elevational view showing a configuration of another charging circuit substrate;
FIG. 15C is a top view showing a configuration of another charging circuit substrate;
FIG. 16 is a diagram illustrating a method for assembling a circuit unit according to a fourth embodiment of the present invention; and
FIG. 17 is a cross-sectional view showing an example to which the present invention is applied.

### DETAILED DESCRIPTION OF THE PREFERRED EMBODIMENTS

### (First embodiment)

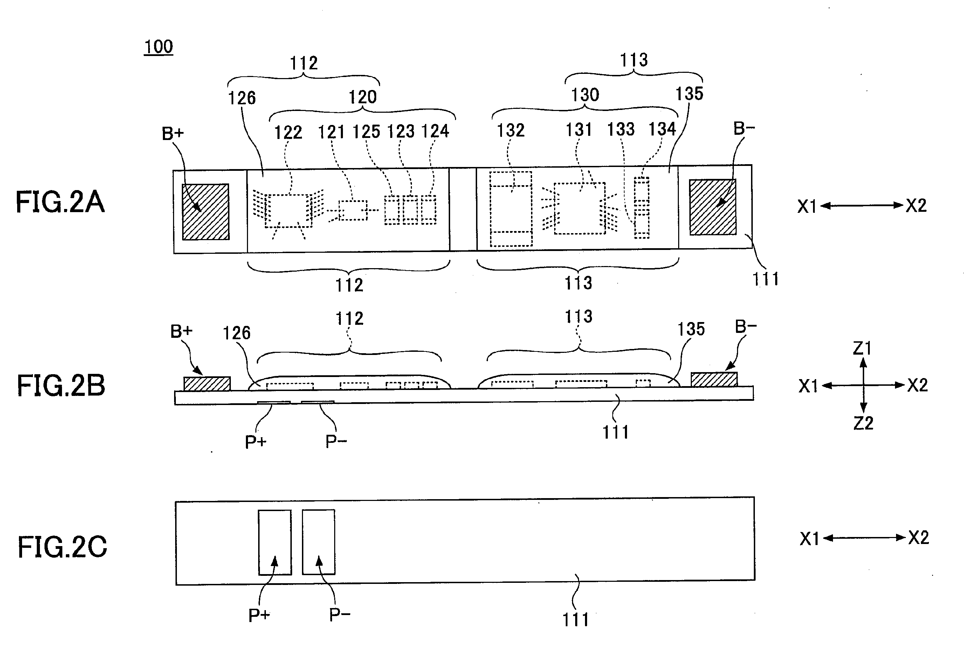

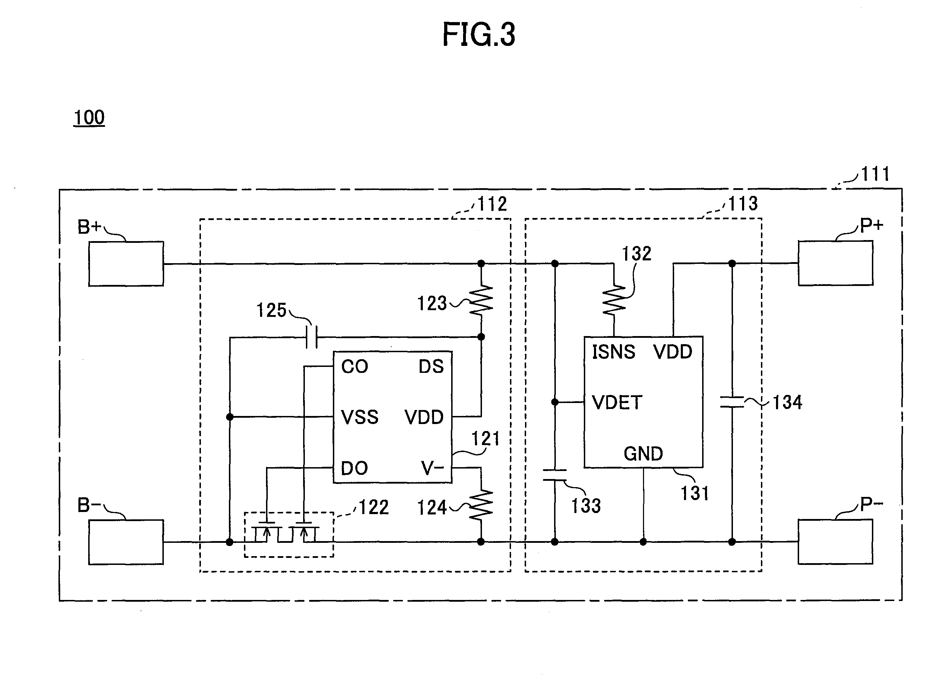

FIG. 2A is a top view showing a configuration according to a first embodiment of the present invention. FIG. 2B is a side elevational view showing the configuration according to the first embodiment of the present invention. FIG. 2C is a bottom view showing the configuration according to the first embodiment of the present invention. FIG. 3 is a diagram showing a block configuration according to the first embodiment of the present invention.

A circuit module 100 in the present embodiment includes a protection circuit unit 112, a charging circuit unit 113, and nickel blocks B+ and B- mounted on a single multilayer printed wiring board 111.

The multilayer printed wiring board 111 has a substantially rectangular shape. The nickel block B+ is soldered at an end in an arrow X1 direction on one surface, namely, on a surface in an arrow Z1 direction. The nickel block B- is soldered at an end in an arrow X2 direction. The nickel block B+ is connected via a terminal board to an anode of a battery built in a battery pack. The nickel block B- is connected via a terminal board to a cathode of the battery built in the battery pack.

Further, on the multilayer printed wiring board 111, connection patterns P+ and P- are exposed in the arrow X1 direction on the other surface, namely, on a surface in an arrow Z2 direction.

The protection circuit unit 112 has so called a COB (chop on board) structure in which electronic components 120 such as a protection IC 121, a MOSFET 122, resistances 123 and 124, a capacitor 125, and the like are mounted on a surface of a conductive pattern on the multilayer printed wiring board 111. In this case, the protection IC 121 is constituted using a bare chip, for example. The protection circuit unit 112 is constituted by mounting the electronic components 120 on a surface of an area in the arrow X1 direction between the nickel block B+ and the nickel block B- on the multilayer printed wiring board 111.

The electronic components 120 are sealed with resin 126. The terminal board having one end connected to the anode of the battery is welded to the nickel block B+ via the other end and the terminal board having one end connected to the cathode of the battery is welded to the nickel block B- via the other end.

The protection IC 121 detects a status immediately before the overcharge, overdischarge, and overcurrent of the battery in accordance with voltage generated in the resistances 123 and 124, for example, and also detects the overheat state using an internal circuit. The protection IC 121 turns off the MOSFET 122 upon detecting a status immediately before the overcharge, overdischarge, overcurrent, and overheat of the battery. In accordance with this, the protection IC 121 protects the battery from falling into the overcharge state, overdischarge state, overcurrent state, and overheat state by disconnecting the cathode of the battery from the connection pattern P-, the cathode of the battery being connected via the terminal board to the nickel block B-, so as to separate the battery from load.

The charging circuit unit 113 is constituted by mounting electronic components 130 on a surface of an area in the arrow X2 direction between the nickel block B+ and the nickel block B-on the multilayer printed wiring board 111. The charging circuit unit 113 is constituted using a circuit block different from that of the protection circuit unit 112.

The charging circuit unit 113 has so called a COB structure in which the electronic components 130 such as a charging IC 131, a resistance 132, capacitors 133 and 134, and the like are mounted on a surface of the conductive pattern on the multilayer printed wiring board 111. In this case, the charging IC 131 is constituted using a bare chip, for example.

The charging IC 131 detects voltage between the nickel block B+ and the nickel block Band also detects current flown to the battery in accordance with voltage applied to the resistance 132. The charging IC 131 controls a built-in MOSFET and performs charging control of the battery in accordance with the detected voltage and current.

Moreover, the electronic components 130 are sealed with resin 135. The resin 135 is separated from the resin 126 for sealing the electronic components 120 of the protection circuit unit 112 on the multilayer printed wiring board 111.

Heat generation of the charging circuit unit 113 is larger than that of the protection circuit unit 112. In this case, by forming different circuit blocks as the charging circuit unit 113 and the protection circuit unit 112, it is possible to reduce transfer of heat generated in the charging circuit unit 113 to the protection circuit unit 112. Further, by separating the resin 126 sealing the protection circuit unit 112 from the resin 135 sealing the charging circuit unit 113 on the multilayer printed wiring board 111, it is possible to further reduce the transfer of heat generated in the charging circuit unit 113 to the protection circuit unit 112.

In the present embodiment, the charging control of the charging IC 131 is described. However, a function may be set so as to detect the voltage between the nickel block B+ and the nickel block B- and also detect the current flown from the battery in accordance with the voltage applied to the resistance 132, so that the built-in MOSFET is controlled and the charging control of the battery is performed in accordance with the detected voltage and current.

According to the present embodiment, it is possible to reduce an influence of the heat generated in the charging circuit unit 113 on the protection circuit unit 112, so that it is possible to mount the protection circuit unit 112 and the charging circuit unit 113 on the single multilayer printed wiring board 111. Moreover, by mounting the protection circuit unit 112 and the charging circuit unit 113 on the single multilayer printed wiring board 111, it is possible to make the circuit module 100 thin.

### (Second embodiment)

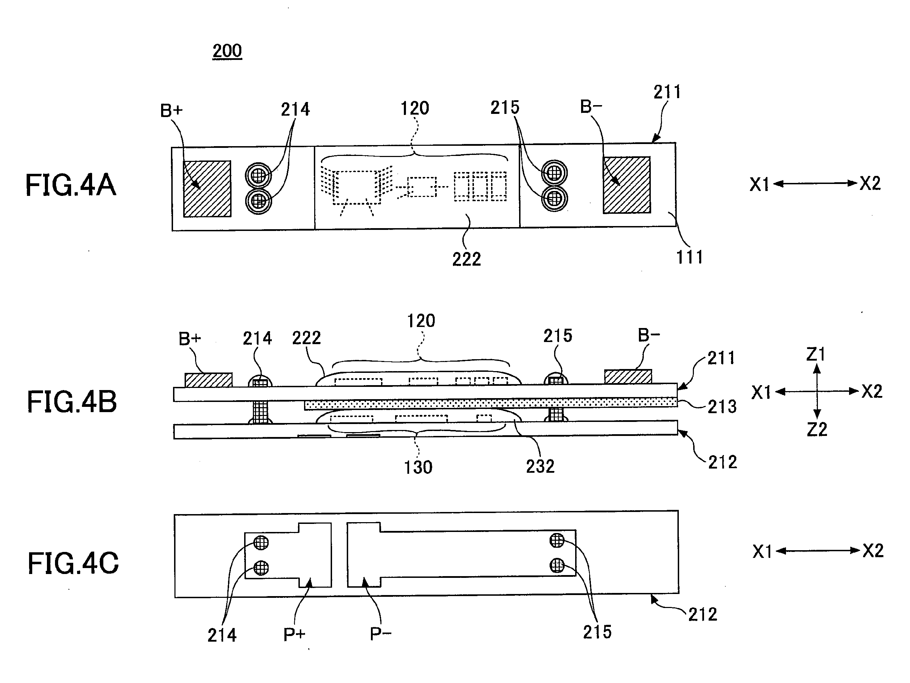

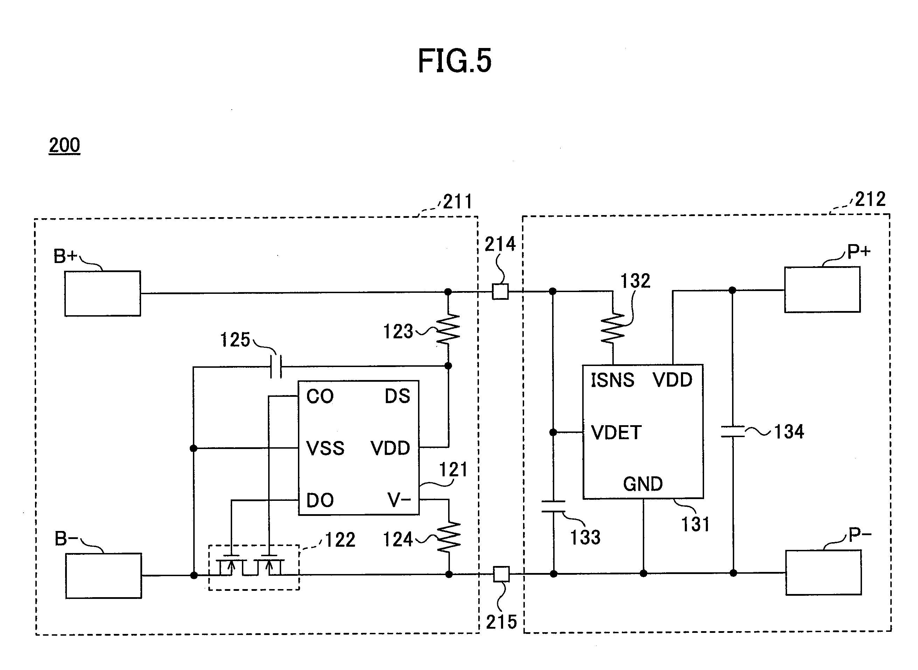

FIG. 4A is a top view showing a configuration according to a second embodiment of the present invention. FIG. 4B is a side elevational view showing the configuration according to the second embodiment of the present invention. FIG. 4C is a bottom view showing the configuration according to the second embodiment of the present invention. FIG. 5 is a diagram showing a block configuration according to the second embodiment of the present invention. In the drawings, the same reference numerals are assigned to the same constituent elements as in FIGS. 2A, 2B, 2C, and 3 and description thereof is omitted.

In a circuit module 200 according to the present embodiment, a protection circuit substrate 211, a charging circuit substrate 212, and a radiator plate 213 are laminated, connecting pins 214 and 215 penetrate therethrough and are soldered at the protection circuit substrate 211 and the charging circuit substrate 212, so that the protection circuit substrate 211, charging circuit substrate 212, and radiator plate 213 are formed in an integrated manner.

First, a configuration of the protection circuit substrate 211 is described.

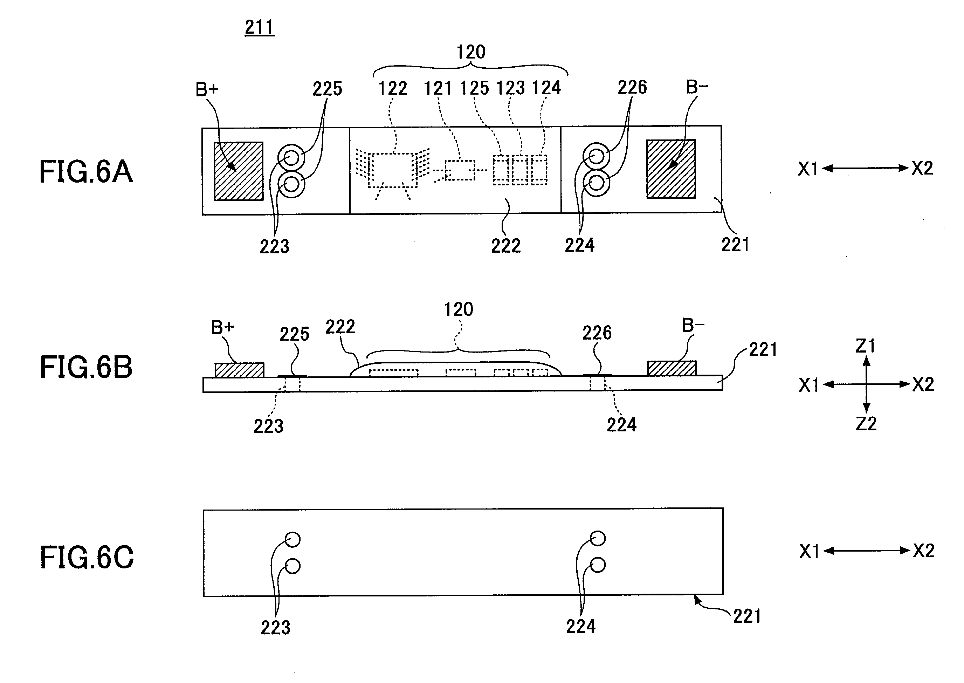

FIG. 6A is a top view showing the configuration of the protection circuit substrate 211. FIG. 6B is a side elevational view showing the configuration of the protection circuit substrate 211. FIG. 6C is a bottom view showing the configuration of the protection circuit substrate 211.

In the protection circuit substrate 211, the electronic components 120, nickel block B+, and nickel block B- are mounted on top surface of a multilayer printed wiring board 221 in the arrow Z1 direction. The electronic components 120 are sealed with resin 222. In the protection circuit substrate 211, through holes 223 and 224 are formed thereon.

On a peripheral portion of the through hole 223 on a surface of the multilayer printed wiring board 221 in the arrow Z1 direction, a connection pattern 225 is formed. The connection pattern 225 is connected to the nickel block B+. The connecting pin 214 is inserted into the through hole 223. The connecting pin 214 is soldered at the connection pattern 225 formed on the peripheral portion of the through hole 223 and is fixed on the protection circuit substrate 211.

On a peripheral portion of the through hole 224 on the surface of the multilayer printed wiring board 221 in the arrow Z1 direction, a connection pattern 226 is formed. The connection pattern 226 is connected to the nickel block B-. The connecting pin 215 is inserted into the through hole 224. The connecting pin 215 is soldered at the connection pattern 226 formed on the peripheral portion of the through hole 224 and is fixed on the protection circuit substrate 211.

Next, a configuration of the charging circuit substrate 212 is described.

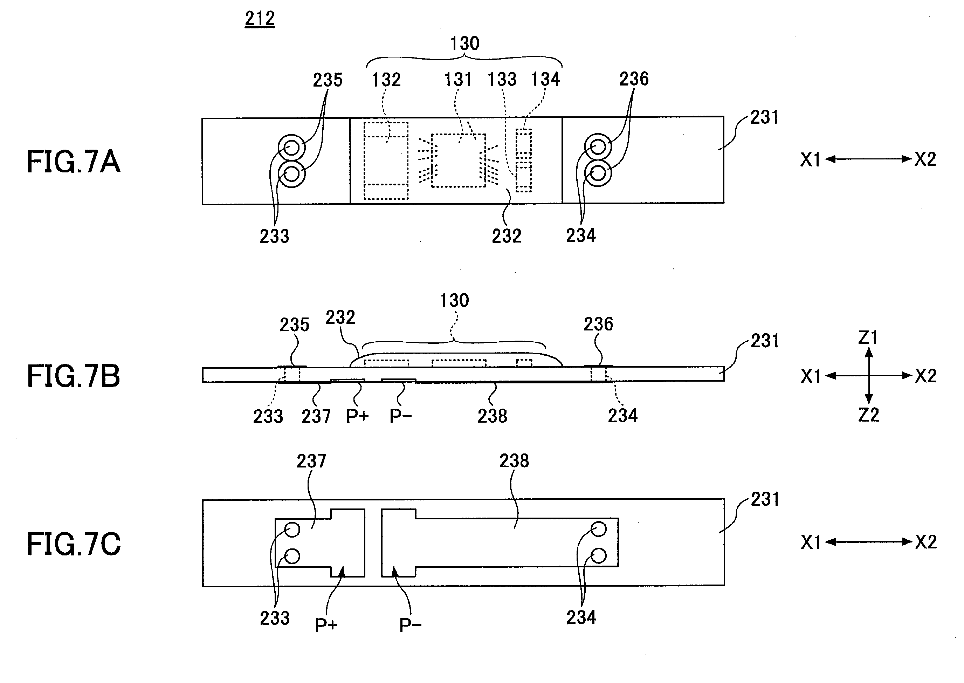

FIG. 7A is a top view showing the configuration of the charging circuit substrate 212. FIG. 7B is a side elevational view showing the configuration of the charging circuit substrate 212. FIG. 7C is a bottom view showing the configuration of the charging circuit substrate 212.

The charging circuit substrate 212 is constituted by mounting the electronic components 130 on a top surface of a multilayer printed wiring board 231 in the arrow Z1 direction. The electronic components 130 are sealed with resin 232. In the charging circuit substrate 212, through holes 233 and 234 are formed thereon.

On a peripheral portion of the through hole 233 on a surface of the multilayer printed wiring board 231 in the arrow Z1 direction, a connection pattern 235 connected to the connection pattern P+ is formed. The connecting pin 214 is inserted into the through hole 233. The connecting pin 214 is soldered at the connection pattern 235 and is fixed on the charging circuit substrate 212.

On a peripheral portion of the through hole 233 on a surface of the multilayer printed wiring board 231 in the arrow Z2 direction, a connection pattern 237 connected to the connection pattern P+ is formed. The connection pattern 237 connects the through hole 233 to the connection pattern P+.

On a peripheral portion of the through hole 234 on the surface of the multilayer printed wiring board 231 in the arrow Z1 direction, a connection pattern 236 connected to the connection pattern P- is formed. The connecting pin 215 is inserted into the through hole 234. The connecting pin 215 is soldered at the connection pattern 236 and is fixed on the charging circuit substrate 212.

On a peripheral portion of the through hole 234 on the surface of the multilayer printed wiring board 231 in the arrow Z2 direction, a connection pattern 238 connected to the connection pattern P- is formed. The connection pattern 238 connects the through hole 234 to the connection pattern P-.

Next; a configuration of the radiator plate 213 is described.

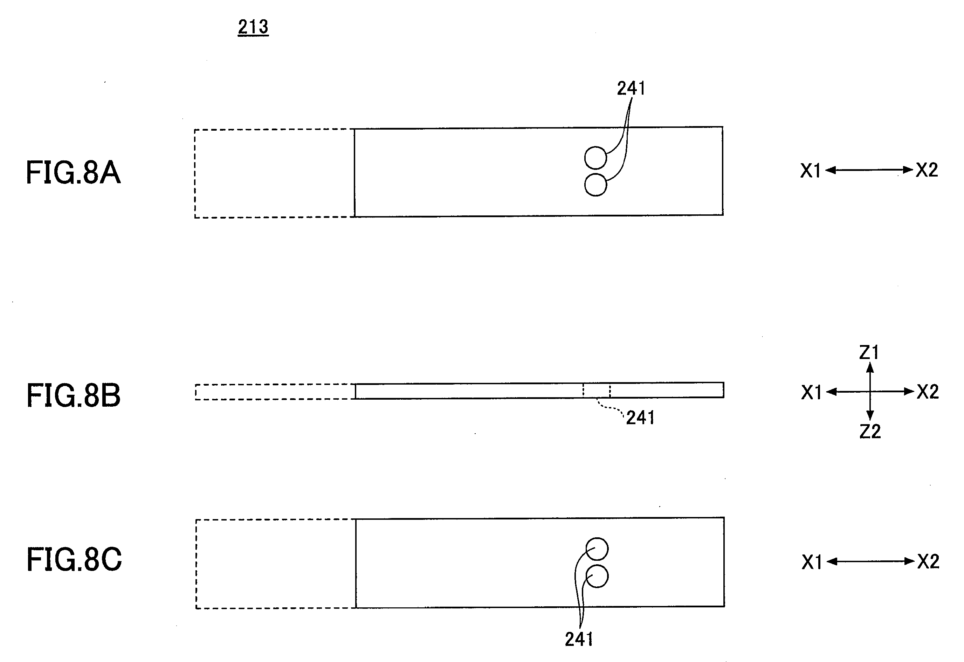

FIG. 8A is a top view showing the configuration of the radiator plate 213. FIG. 8B is a side elevational view showing the configuration of the radiator plate 213. FIG. 8C is a bottom view showing the configuration of the radiator plate 213.

The radiator plate 213 is prepared by forming a material superior in thermal conductively such as aluminum, copper, or the like into a platelike shape. The shape is determined so as to cover the electronic components 130 constituting the charging circuit of the charging circuit substrate 212 and above the charging circuit substrate 212 in the arrow Z2 direction. Penetration holes 241 are formed at positions corresponding to the through holes 224 of the protection circuit substrate 211 and the through holes 234 of the charging circuit substrate 212. The connecting pin 215 is inserted into the penetration hole 241. The radiator plate 213 is in contact with a top surface of the resin 232 in the arrow Z1 direction and has a function of radiating heat generated in the electronic components 130.

Next, a method for assembling the circuit module 200 is described.

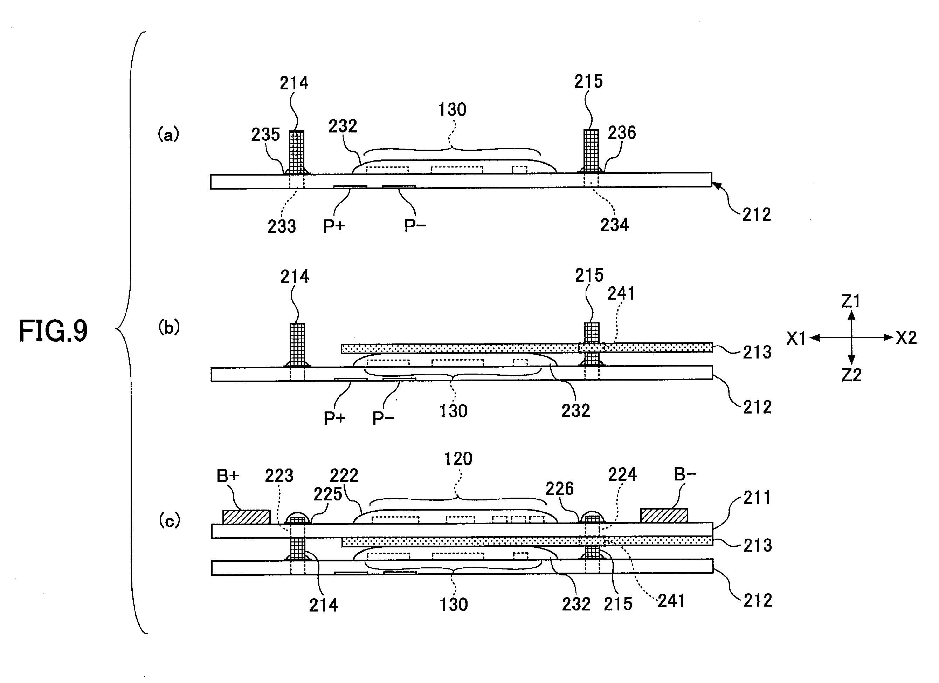

FIG. 9 is a diagram illustrating the method for assembling the circuit unit 200 according to the second embodiment of the present invention.

First, the connecting pin 214 is inserted into the through hole 233 and the connecting pin 215 is inserted into the through hole 234 in the charging circuit substrate 212. In this case, the connecting pins 214 and 215 are positioned such that end faces thereof in the arrow Z2 direction correspond to the surface of the charging circuit substrate 212 in the arrow Z2 direction. The connecting pin 214 is soldered at the connection pattern 235 formed on the peripheral portion of the through hole 233 and the connecting pin 215 is soldered at the connection pattern 236 formed on the peripheral portion of the through hole 234.

In accordance with this, the connecting pins 214 and 215 are implanted in the charging circuit substrate 212 as shown in FIG. 9-(a).

Next, as shown in FIG. 9-(b), the connecting pin 215 is allowed to penetrate through the penetration hole 241 of the radiator plate 213, so that the radiator plate 213 is disposed on the resin 232. In this case, the radiator plate 213 may be bonded to the resin 232 or to the protection circuit substrate 211 using adhesive, for example. In the present embodiment, the radiator plate 213 is extended in the arrow X2 direction. However, by further extending the radiator plate 213 in the arrow X1 direction so as to increase an area thereof, efficiency of heat radiation is improved.

Next, the protection circuit substrate 211 is laminated on the charging circuit substrate 212 and the radiator plate 213 such that the connecting pin 214 penetrates through the through hole 223 and the connecting pin 215 penetrates through the through hole 224. The connecting pins are soldered at the connection pattern 225 formed on the peripheral portion of the through hole 223 and the connection pattern 226 formed on the peripheral portion of the through hole 224.

In accordance with this, as shown in FIGS. 4A, 4B, 4C, and FIG. 9-(c), the protection circuit substrate 211, charging circuit substrate 212, and radiator plate 213 are formed in an integrated manner.

By laminating the protection circuit substrate 211 and the charging circuit substrate 212 in an integrated manner, it is possible to form a circuit module having a protection function and a charging function with the same projected area as in a conventional circuit module having only a protection function. In accordance with this, it is possible to construct a battery pack with the same cross-sectional area as in a conventional battery pack on which a circuit module having only a protection circuit is mounted.

Further, in the present embodiment, by disposing the radiator plate 213, it is possible to efficiently radiate heat generated in the electronic components 120 constituting the charging circuit.

### (Third embodiment)

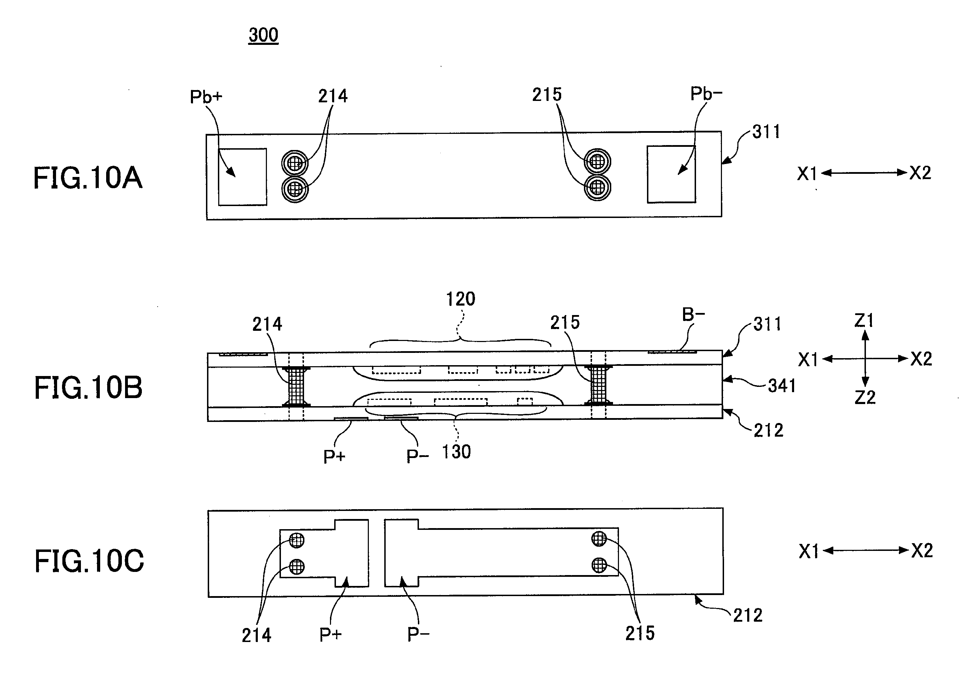

FIG. 10A is a top view showing a configuration according to a third embodiment of the present invention. FIG. 10B is a side elevational view showing the configuration according to the third embodiment of the present invention. FIG. 10C is a bottom view showing the configuration according to the third embodiment of the present invention. In the drawings, the same reference numerals are assigned to the same constituent elements as in FIGS. 4A, 4B, and 4C and description thereof is omitted.

A circuit module 300 according to the present embodiment has a configuration in which the electronic components 120 constituting the protection circuit of a protection circuit substrate 311 and the electronic components 130 constituting the charging circuit of the charging circuit substrate 212 are disposed in an opposing manner. A configuration of the protection circuit substrate 311 is different from the case of the second embodiment.

In the following, the protection circuit substrate 311 according to the present embodiment is described.

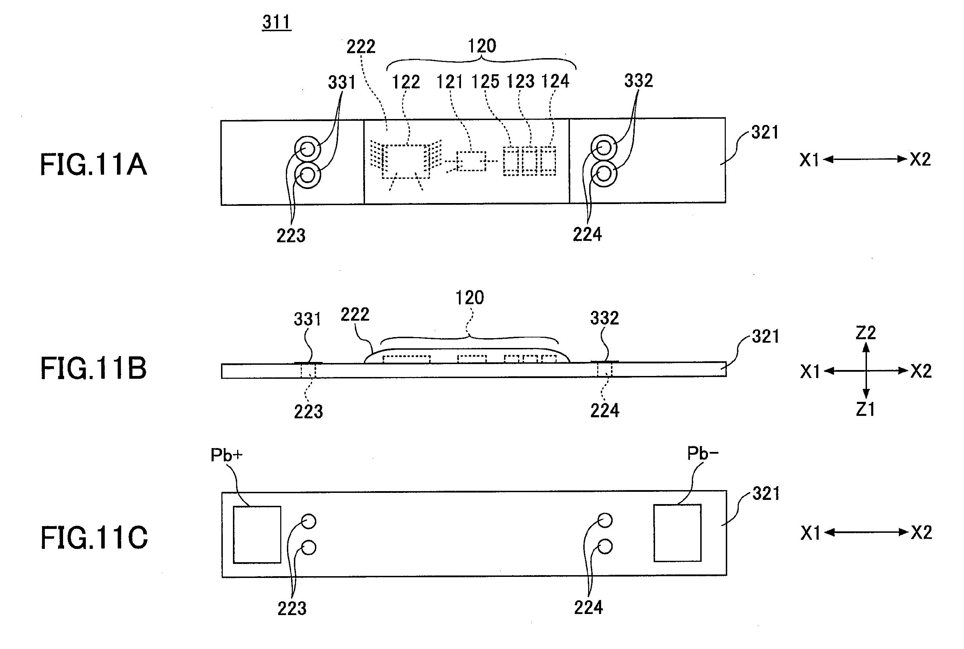

FIG. 11A is a bottom view showing a configuration of the protection circuit substrate 311. FIG. 11B is a side elevational view showing the configuration of the protection circuit substrate 311. FIG. 11C is a top view showing the configuration of the protection circuit substrate 311.

The protection circuit substrate 311 according to the present embodiment has a configuration in which the electronic components 120 constituting the protection circuit are mounted on a surface of a multilayer printed wiring board 321 in the arrow Z2 direction and battery connection patterns Pb+ and Pb- are formed on a surface of the multilayer printed wiring board 321 in the arrow Z1 direction. The multilayer printed wiring board 321 has the through holes 223 and 224 and connection patterns 331 and 332 are formed on a peripheral portion of the through holes 223 and 224 on the surface in the arrow Z2 direction. The connecting pins 214 and 215 are soldered at the connection patterns 331 and 332.

In addition, the charging circuit substrate 212 has the same configuration as in the charging circuit substrate 212 shown in FIGS. 7A, 7B, and 7C.

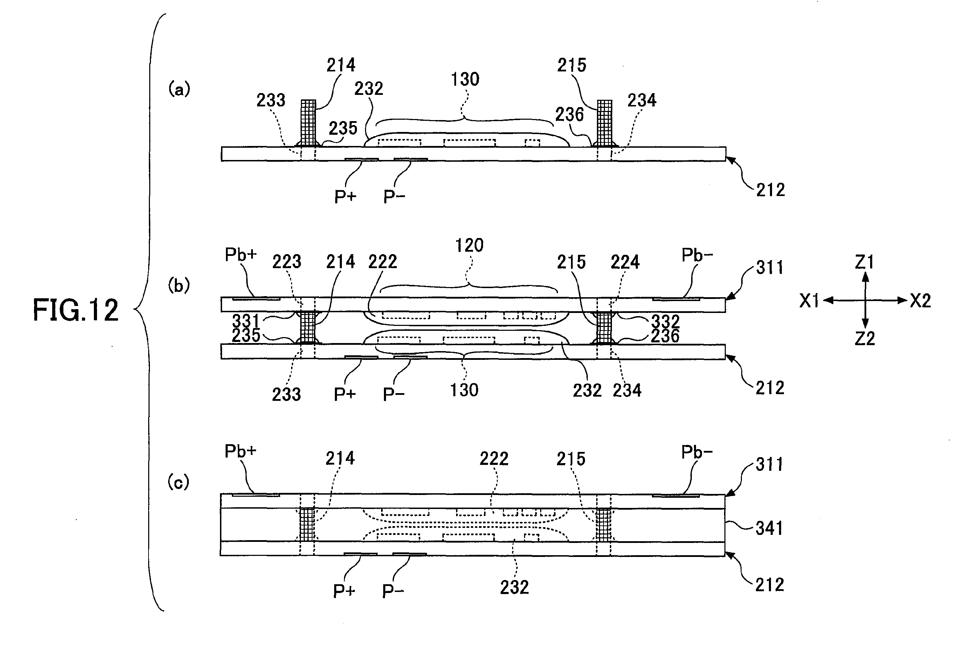

FIG. 12'is a diagram illustrating a method for assembling the circuit module 300 according to the third embodiment of the present invention.

First, the connecting pin 214 is inserted into the through hole 233 and the connecting pin 215 is inserted into the through hole 234 in the charging circuit substrate 212. In this case, the connecting pins 214 and 215 are positioned such that end faces thereof in the arrow Z2 direction correspond to the surface of the charging circuit substrate 212 in the arrow Z2 direction. The connecting pin 214 is soldered at the connection pattern 235 formed on the peripheral portion of the through hole 233 and the connecting pin 215 is soldered at the connection pattern 236 formed on the peripheral portion of the through hole 234. It is possible to perform soldering between the connecting pins 214 and 215 and the connection patterns 235, 236, 331, and 332 via flow soldering, reflow soldering, or the like.

Next, as shown in FIG. 12-(b), the protection circuit substrate 311 is laminated on the charging circuit substrate 212 such that the connecting pin 214 is inserted into the through hole 223 and the connecting pin 215 is inserted into the through hole 224. The connecting pins 214 and 215 are soldered at the connection pattern 331 formed at the peripheral portion of the through hole 223 and the connection pattern 332 formed at the peripheral portion of the through hole 224.

In accordance with this, the protection circuit substrate 311 and charging circuit substrate 212 are laminated and formed in an integrated manner.

Next, as shown in FIG. 12-(c), resin 341 is filled between the protection circuit substrate 311 and the charging circuit substrate 212 so as to dispose and seal the electronic components 120 constituting the protection circuit and the electronic components 130 constituting the charging circuit between the protection circuit substrate 311 and the charging circuit substrate 212.

By laminating the protection circuit substrate 311 and the charging circuit substrate 212 in an integrated manner, it is possible to form a circuit module having a protection function and a charging function with the same projected area as in a conventional circuit module having only a protection function. In accordance with this, it is possible to construct a battery pack with the same cross-sectional area as in a conventional battery pack.

Further, according to the present embodiment, the protection circuit substrate 311 and the charging circuit substrate 212 are laminated in an integrated manner via the resin 341, so that it is possible to substantially improve mechanical strength of the circuit module 300.

Moreover, the electronic components 120 constituting the protection circuit and the electronic components 130 constituting the charging circuit are disposed between the protection circuit substrate 311 and the charging circuit substrate 212. Thus, it is possible to completely seal the electronic components 120 constituting the protection circuit of the protection circuit substrate 311 and the electronic components 130 constituting the charging circuit of the charging circuit substrate 212 with the resin 341 and to improve reliability of the circuit module 300.

In the present embodiment, the electronic components 120 mounted on the protection circuit substrate 311 and the electronic components 130 mounted on the charging circuit substrate 212 are sealed with the resin 222 and 232, then the protection circuit substrate 311 and the charging circuit substrate 212 are laminated in an integrated manner such that the electronic components 120 and the electronic components 130 are disposed in an opposing manner, and the electronic components 120 and the electronic components 130 are further sealed with the resin 341. However, before the sealing with the resin 222 and resin 232, namely, while the bare chip is exposed, the protection circuit substrate 311 and the charging circuit substrate 212 may be laminated in an integrated manner such that the electronic components 120 and the electronic components 130 are disposed in an opposing manner and the electronic components 120 and the electronic components 130 may be sealed by filling the resin 341 between the protection circuit substrate 311 and the charging circuit substrate 212.

In accordance with this, it is possible to eliminate the step of sealing the electronic components 120 and 130 with the resin 222 and 232.

### (Fourth embodiment)

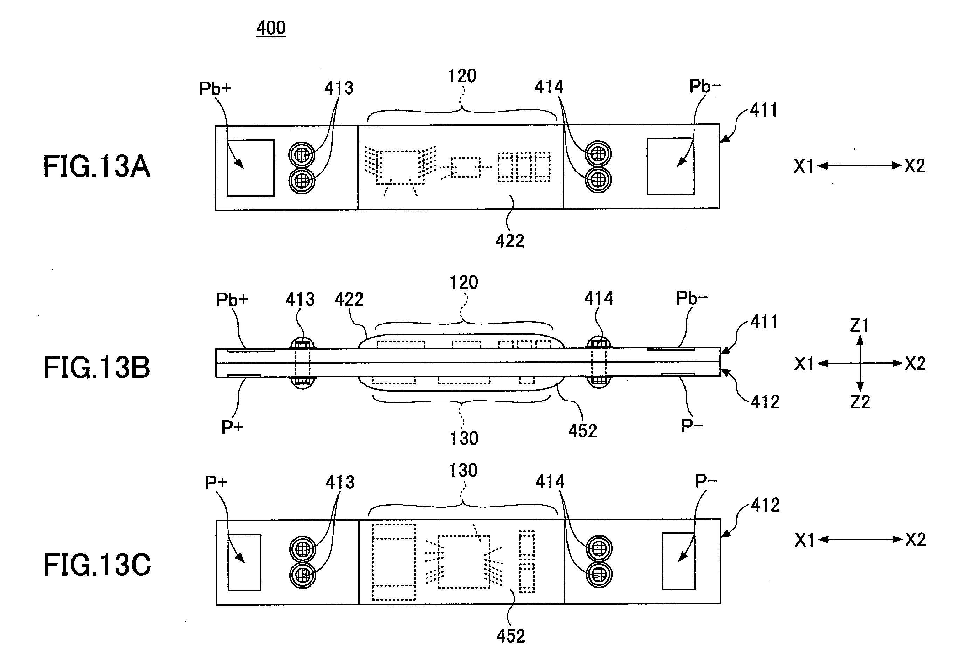

FIG. 13A is a top view showing a configuration according to a fourth embodiment of the present invention. FIG. 13B is a side elevational view showing the configuration according to the fourth embodiment of the present invention. FIG. 13C is a bottom view showing the configuration according to the fourth embodiment of the present invention. In the drawings, the same reference numerals are assigned to the same constituent elements as in FIGS. 4A, 4B, and 4C and description thereof is omitted.

A circuit module 400 according to the present embodiment has a configuration in which a protection circuit substrate 411 and a charging circuit substrate 412 are laminated via connecting pins 413 and 414.

In the following, the protection circuit substrate 411 according to the present embodiment is described.

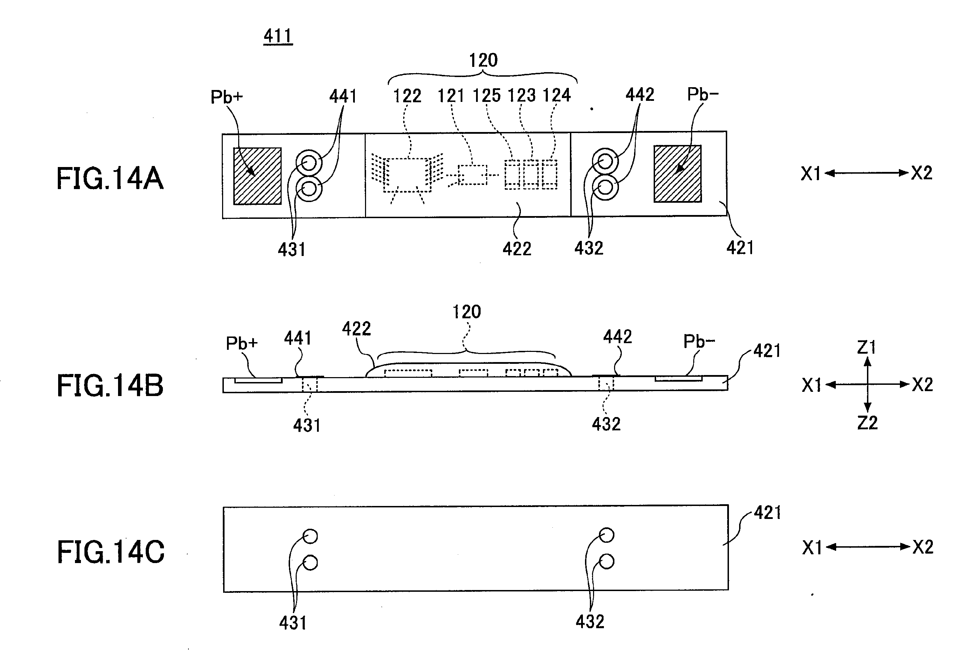

FIG. 14A is a top view showing a configuration of the protection circuit substrate 411. FIG. 14B is a side elevational view showing the configuration of the protection circuit substrate 411. FIG. 14C is a bottom view showing the configuration of the protection circuit substrate 411.

The protection circuit substrate 411 according to the present embodiment has a configuration in which the electronic components 120 constituting the protection circuit are mounted on a surface of a multilayer printed wiring board 421 in the arrow Z1 direction and are sealed with resin 422. Further, the battery connection patterns Pb+ and Pb- are formed on the surface of the multilayer printed wiring board 421 in the arrow Z1 direction. A battery is connected to the battery connection patterns Pb+ and Pb-.

Moreover, through holes 431 and 432 penetrating trough the multilayer printed wiring board 421 in the arrows Z1 and Z2 directions are formed between the resin 422 and the battery connection patterns Pb+ and Pb- on the multilayer printed wiring board 421. Connection patterns 441 and 442 are formed on peripheral portions of the through holes 431 and 432 on the surface of the multilayer printed wiring board 421 in the arrow Z1 direction. The connecting pins 413 and 414 are soldered at the connection patterns 441 and 442.

In the following, the charging circuit substrate 412 according to the present embodiment is described.

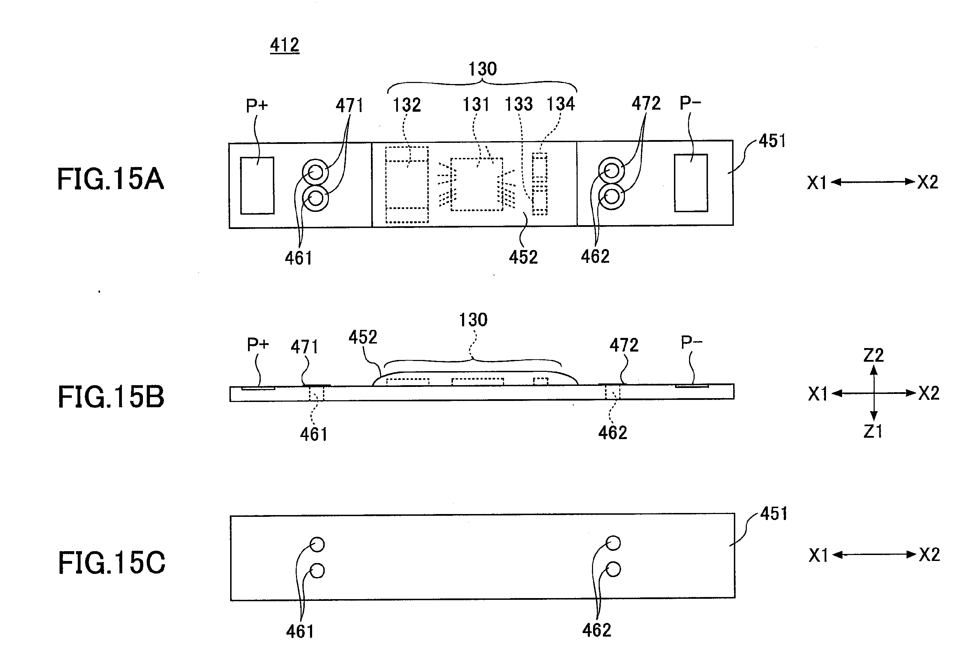

FIG. 15A is a bottom view showing a configuration of the charging circuit substrate 412. FIG. 15B is a side elevational view showing the configuration of the charging circuit substrate 412. FIG. 15C is a top view showing the configuration of the charging circuit substrate 412.

The charging circuit substrate 412 according to the present embodiment has a configuration in which the electronic components 130 constituting the charging circuit are mounted on a surface of a multilayer printed wiring board 451 in the arrow Z2 direction and are sealed with resin 452. On the surface of the multilayer printed wiring board 451 in the arrow Z2 direction, the connection patterns P+ and P- are formed. The connection patterns P+ and P- are used as charging and discharging terminals of a battery pack.

Moreover, in the multilayer printed wiring board 451, through holes 461 and 462 penetrating trough the multilayer printed wiring board 451 in the arrows Z1 and Z2 directions are formed between the resin 452 and the connection patterns P+ and P-. On peripheral portions of the through holes 461 and 462 on the surface of the multilayer printed wiring board 451 in the arrow Z2 direction, connection patterns 471 and 472 are formed. The connecting pins 413 and 414 are soldered at the connection patterns 471 and 472.

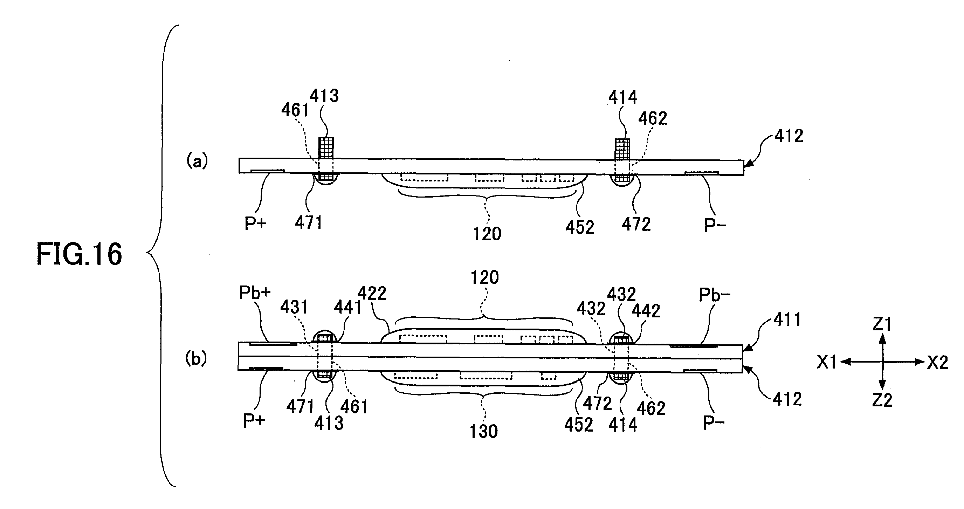

FIG. 16 is a diagram illustrating a method for assembling the circuit module 400 according to the fourth embodiment of the present invention.

First, as shown in FIG. 16-(a), the connecting pin 413 is inserted into the through hole 461 and the connecting pin 414 is inserted into the through hole 462 in the charging circuit substrate 412. The connecting pin 413 is soldered at the connection pattern 471 formed on the peripheral portion of the through hole 461 and the connecting pin 414 is soldered at the connection pattern 472 formed on the peripheral portion of the through hole 462.

Next, as shown in FIG. 16-(b), the protection circuit substrate 411 is laminated on the charging circuit substrate 412 such that the connecting pin 413 is inserted into the through hole 431 and the connecting pin 414 is inserted into the through hole 432. The connecting pin 413 is soldered at the connection pattern 441 formed on the peripheral portion of the through hole 431 and the connecting pin 414 is soldered at the connection pattern 442 formed on the peripheral portion of the through hole 432.

In accordance with this, it is possible to form the protection circuit substrate 411 and the charging circuit substrate 412 in an integrated manner. In the above-mentioned second to fourth embodiments, by connecting a power supply to the ground using the connecting pins 214 and 413 connected to a power supply terminal and the connecting pins 215 and 414 connected to a ground terminal, it is possible to reduce resistance resulting from the pattern wiring.

### (Application example)

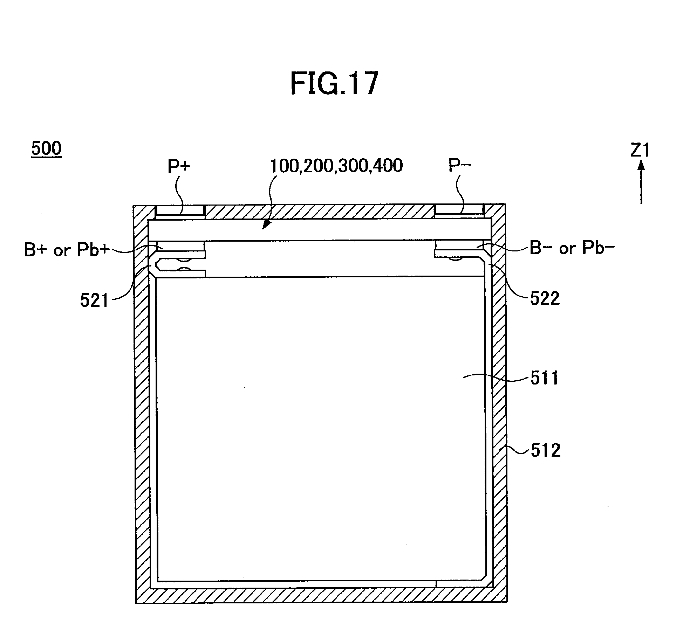

FIG. 17 is a cross-sectional view showing an example to which the present invention is applied.

In the present application example, a battery pack 500 including the circuit modules 100, 200, 300, and 400 built therein is described.

The battery pack 500 has a configuration in which a battery 511, the circuit modules 100, 200, 300, and 400 are stored in a case 512. In the circuit modules 100, 200, 300, and 400, one end of a connection member 521 is welded to the nickel block B+ or the battery connection pattern Pb+ and one end of a connection member 522 is welded to the nickel block B- or the battery connection pattern Pb-. The other end of the connection member 521 is connected to an anode of the battery 511 and the other end of the connection member 522 is connected to a cathode of the battery 511.

In addition, the circuit modules 100, 200, 300, and 400 are stored in the case 512 such that the connection pattern P+ and P- are exposed on an end surface of the case 512 in the arrow Z1 direction.

The present invention is not limited to the specifically disclosed embodiment, and variations and modifications may be made without departing from the scope of the present invention.

## Claims

1. A circuit module **characterized by**:
a substrate;
a protection circuit mounted on the substrate for protecting a battery; and
a charging circuit disposed on the substrate for controlling charging and discharging of the battery.

2. The circuit module according to claim 1, wherein
the protection circuit and the charging circuit are sealed with resin.

3. The circuit module according to claim 1, wherein
an electronic component constituting the protection circuit and an electronic component constituting the charging circuit are mounted on a surface of one side of the substrate.

4. A circuit module **characterized by**:
a first circuit substrate constituting a first circuit; and
a second circuit substrate constituting a second circuit, wherein
the first circuit substrate and the second circuit substrate are laminated and connected using a conductive member.

5. The circuit module according to claim 4, wherein
the first circuit substrate and the second circuit substrate are laminated via a radiator plate and connected using the conductive member.

6. The circuit module according to claim 4, wherein
an electronic component constituting the first circuit is mounted on a surface of one side of the first circuit substrate,
an electronic component constituting the second circuit is mounted on a surface of one side of the second circuit substrate, and
the first circuit substrate and the second circuit substrate are laminated so as to dispose the surface of one side of the first circuit substrate and the surface of one side of the second circuit substrate in an opposing manner and are connected using the conductive member.

7. The circuit module according to claim 6, wherein
a clearance between the first circuit substrate and the second circuit substrate is sealed with resin.

8. The circuit module according to claim 4, wherein
an electronic component constituting the first circuit is mounted on a surface of one side of the first circuit substrate,
an electronic component constituting the second circuit is mounted on a surface of one side of the second circuit substrate, and
the first circuit substrate and the second circuit substrate are laminated so as to dispose a surface of the other side of the first circuit substrate and a surface of the other side of the second circuit substrate in an opposing manner and are connected using the conductive member.

9. The circuit module according to any one of claims 4 to 8, wherein
the first circuit functions as a protection circuit for protecting a battery,
the second circuit functions as a charging circuit for controlling charging of the battery, and
the conductive member includes a first conductive member connected to a power supply terminal and a second conductive member connected to a ground terminal.
